# EUROPEAN PATENT APPLICATION

(11) **EP 4 534 876 A1**
(43) Date of publication of application: **09.04.2025**
(21) Application number: 24189127.4
(22) Date of filing: 17.07.2024
(51) Int. Cl.: F16K 3/02, F16K 3/18, F16K 51/02, H01J 37/09, H01J 37/18

(54) **VALVES FOR CHARGED PARTICLE BEAM MICROSCOPE, VALVE MEMBER AND CHARGED PARTICLE BEAM MICROSCOPE**

(30) Priority: 18.07.2023 DE 102023118986
(71) Applicant: Carl Zeiss MultiSEM GmbH, 73447 Oberkochen (DE)
(72) Inventor: BALLING, Steffen, 73447 Oberkochen (DE); SCHINDLER, Bernd, 73447 Oberkochen (DE); SCHWARZ, Daniel, 73447 Oberkochen (DE); GRIES, Katharina, 64380 Rossdorf (DE); BATZ, Marion, 64380 Rossdorf (DE); LAEMMLE, David, 64380 Rossdorf (DE)
(74) Representative: Kraus & Lederer PartGmbB

(57) **Abstract**

In one implementation, a valve for a charged particle beam microscope is provided , comprising:
a valve seat (12) comprising an opening (11), and a valve member comprising a valve member body (13) and a sealing ring (14) on a first surface of the valve member body (13). The valve member is movable between a first position where the sealing ring (14) seals around the opening (11) and a second position where the valve member is spaced apart from the opening (11). The valve member further comprises an electrically conducting shielding member (15) extending at least at a side surface of the valve member body (13) facing the opening (11) in the second position.

## Description

### TECHNICAL FIELD

The present application relates to valves for charged particle beam microscopes, valve members of such valves and to corresponding charged particle beam microscopes

### BACKGROUND

Charged particle beam microscopes are a type of microscopes where a charged particle beam, for example an electron beam or an ion beam, is guided to a sample, and the interaction between the charged particle beam and the sample is used for generating an image. Examples for charged partial beam microscopes are transmission electron microscopes (TEMs) and scanning electron microscopes (SEM). For increasing throughput, such microscopes may also use more than one charged particle beam, for example in so called Multi-SEMs, (MSEM).

Generally, such charged particle beam microscopes include a charged particle beam source for generating the charged particle beam, components to focus the charged particle beam on the sample, for example magnets, and one or more detectors to detect the response, which may for example include reflected charged particle beams, scattered charged particle beams, secondary charged particles like Auger electrons or also other kinds of radiation like x-ray radiation generated.

In most types of charged particle beam microscopes, the charged particle beam is at least for the most part guided through a vacuum onto the sample. At a charged particle beam sourse, usually an ultra high vacuum (UHV) is used (1×10⁻⁹ mbar or better), while in other parts the beam passes through a high vacuum (e.g. 1×10⁻⁶ mbar or better) is sufficient. A valve is used in some configurations to separate a first part where the charged particle beam is generated from a second chamber where the sample resides.

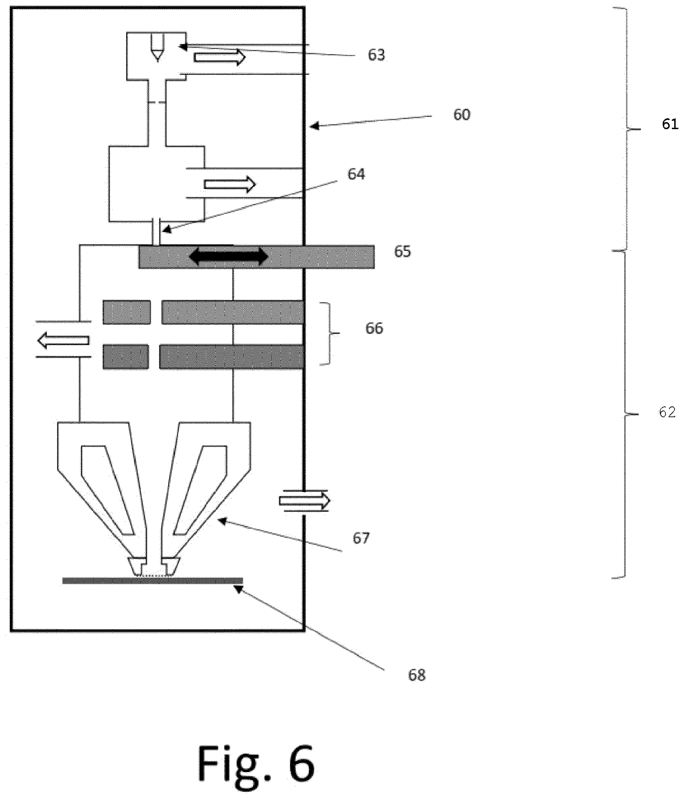

As an example, Fig. 6 shows a columnar arrangement of a charged particle beam microscope 60 including an upper chamber 61 and a lower chamber 62. As indicated by arrows, both upper chamber 61 and lower chamber 62 may be evacuated to generate a vacuum therein.

Upper chamber 61 includes a cathode 63 generating a charged particle beam, e.g. electrons. The charged particle beam leaves upper stage 61 and enters lower stage 62 via a channel (pressure stage) 64. A pressure in lower stage 62 is, as mentioned above, higher than in upper stage 61 (e.g. UHV in upper stage 61, high vacuum in lower stage 62).

The charged particle beam is focused onto a sample 68 via an objective lens 67. Detectors 66 serve for detecting the signal, e.g. scattered particles, secondary particles and/or radiation, as mentioned above. Around detector 66, the pressure again may be higher than in lower stage 62, e.g. 1×10⁻⁵ mbar or less. It should be noted that pressures here are given only by way of example and may vary depending on the implementation.

A valve 65 is provided which may be used to separate upper chamber 61 from lower chamber 62. For example, in case of a loss of vacuum in lower chamber 62, valve 65 may be closed, to preserve the vacuum in upper chamber 61 and protect cathode 63. Also, when charged particle beam microscope is not in use or when the sample is changed, valve 65 may be closed.

The present application generally relates to such valves which may be used in charged particle beam microscopes to separate areas from each other in a gas-tight manner, for example upper chamber 61 and lower chamber 62 of Fig. 6. Other parts of such charged particle beam microscopes may be implemented in any conventional manner, and Fig. 6 shows merely a simple non-limiting example.

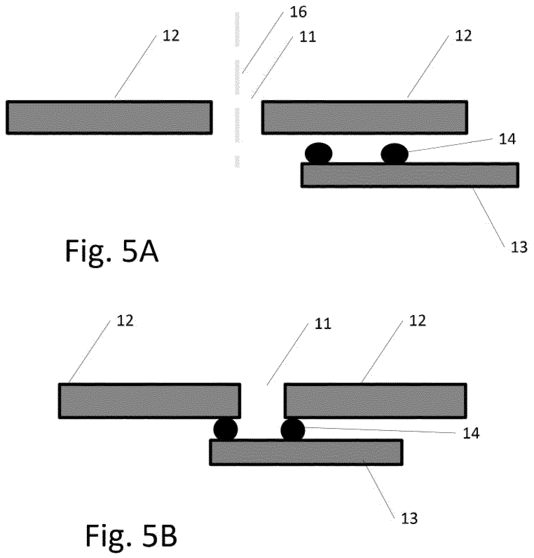

Figs 5A and 5B show a conventional valve used in such charged particle beam microscopes in schematic side views for comparison purposes. Fig. 5A shows the valve in an open position, and fig. 5B shows the valve in a closed position. The valve shown in figs. 5A and 5B includes a valve seat 12 with an opening 11. In operation, a charged particle beam 16, for example electron beam, passes through opening 11 between the above-mentioned chambers. Furthermore, the valve includes a valve member having a valve member body 13 and a sealing ring 14 like an O-ring on a first surface of valve member 13. In an open position, valve member body 13 is retracted, such that opening 11 is open. In a closed position, valve member body 13 presses sealing ring 14 against the circumference of opening 11, thus sealing the opening.

An electrical contact spring (not shown) is provided at a side surface of valve member body 13. In the closed position, electrical contact spring, which is electrically conducting, is in electrical contact to valve seat 12, and in the open position it is in electrical contact to a portion which sometimes is referred to as "valve garage" and is generally referred to a valve housing member herein, and which provides a kind of housing for the valve member. This serves to bring the valve member to a certain electric potential, for example ground in the closed position or an acceleration voltage for the charged particle beam, for example in the Kilovolt range, in the open position.

However, this electrical contact spring may deteriorate over time, for example by corrosion and/or mechanical wear, leading to an undefined potential of the valve member. Furthermore, in the open position shown in fig. 5A sealing ring 14 may be charged by charged particle beam 16. Such effects may lead to a certain deflection of the charged particle beam 16, which may deteriorate image quality or lead to an unstable image position, i.e. to image drift. Furthermore, the electrical contact spring may for example corrode. Furthermore, particles may be generated by the movement and the moving contact between the electrical contact spring and valve seat 12 or a housing, respectively.

### SUMMARY

According to a first aspect, a valve for a charged particle beam microscope is provided, comprising:
a valve seat comprising an opening, and
a valve member comprising a valve member body and a sealing ring on a first surface of the valve member body, wherein the valve member is movable between a first position where the sealing ring seals around the opening and a second position where the valve member is spaced apart from the opening,
wherein the valve member further comprises an electrically conducting shielding member extending at least at a sized surface of the valve member body facing the opening in the second position.

In some embodiments, the shielding member may prevent a charging of the sealing ring in the second position.

The second position may be offset from the first position in a direction parallel to a plane in which the opening is provided. The sealing member may for example be made of a metal.

The shielding member may extend to a height at least corresponding to a height of the sealing ring above the first surface in the second position. In some embodiments, this may provide a good shielding of the sealing ring.

The sealing ring may for example be an O-ring made of a rubber material.

The shielding member may be attached to the second surface of the valve member body opposite the first surface. In some embodiments, this may give some resiliency to the arrangement of the shielding member coupled to the valve member body.

The valve may further comprise a valve housing member which extends below the valve member. In such an embodiment, the shielding member may be configured to electrically contact at least a conducting part of the valve housing member in the second position. This may allow for a biasing of the valve member in the second position via the valve housing member and for shielding member. For example, the valve housing member may be configured to be set to a high voltage potential at least when the valve member is in the second position, such that the valve member is biased with the high voltage potential in the second position via the shielding member.

Furthermore, the shielding member may be configured to electrically contact a conducting portion of the valve seat when the valve member is in the first position. In this way, in the first position the valve member may be biased via the valve seat, for example to a ground potential if the valve seat is configured to be set to a ground potential at least when the valve is in the first position.

In addition, the valve member may include an electrical contact spring at a further side surface thereof, which is configured to receive a first voltage in the first position and a second voltage in the second position, for example the high voltage and ground potential mentioned above. The first voltage may be a high voltage, and the second voltage may correspond to ground.

The valve seat may comprise a further shielding member around the opening, where the sealing ring is configured to abut against the further shielding member in the first position and shielded by the shielding member in the second position. This further shielding member in some embodiments may provide an additional shielding for the sealing ring.

This further shielding member may also be used independently from the shielding member, such that in a second aspect a valve for a charged particle beam microscope is provided, comprising: a valve seat comprising an opening, and a shielding member around the opening, and
a valve member comprising a valve member body and a sealing ring on the first surface of the valve member body, wherein the valve member is movable between a first position where the sealing ring abuts against the shielding member to seal around the opening and a second position where the valve member is spaced for apart from the opening and the sealing ring is shielded by the shielding member.

The valve may further comprise a flexible electrically conducting wire coupled to the valve member body, via which the valve member may be biased, for example to the first and/or second voltage mentioned above. This may also be used independently or in combination with the above features, such that in a third aspect a valve for a charged particle beam microscope is provided, comprising:
A valve seat comprising an opening, and
a valve member comprising a valve member body and a sealing ring on a first surface of the valve member body, wherein the valve member is movable between a first position where the sealing ring seals around the opening and a second position where the valve member is spaced apart from the opening, and a flexible electrically conducting attached to the electrically conducting attached to the valve member body for biasing the valve member.

Furthermore, an electrical contact may be provided adjacent to the valve seat, such that the valve member contacts the electrical contact in the second position. This also serves for biasing the valve member in the second position and may also be used independently from some of the features above. In this respect, the electrical contact may form part of a recess where the valve member is positioned when in the second position. Therefore, according to a fourth aspect a valve for a charged particle beam microscope is provided, comprising a valve seat comprising an opening, and an electrical contact adjacent to the valve seat, and a valve member comprising a valve member body and a sealing ring on a first surface of the valve member body, wherein the valve member is movable between a first position where the sealing ring seals around the opening and a second position where the valve member is spaced apart from the opening and contacts the electrical contact.

In order to reduce friction and particle generation by friction, a suitable vacuum compatible lubricant may be provided at portions where the valve member comes to sliding contact with other parts like the valve housing member. For example, the lubricant may be provided where the shielding member electrically contacts a conducting part of the valve housing member or where the electrical contact spring at the further side surface comes into contact with other elements. The lubricant may be based on a fluoropolymer or a silicone grease. The lubricant may be highly inert, i.e. not prone to entering chemical reactions, and therefore in some embodiments may also protect against corrosion. For example, suitable lubricants may be based on polyfluoroethylene (PFE) with a viscosity of the order of 250-300 mm²/s at 20°C, a TOC (degassing) value of at or below 20ng/mg when at 200°C for 2min as analyzed by GC-MS (combine gas chromatography and mass spectrometry).

This may also be independent from the above, such that according to a fifth aspect a valve for a charged particle beam microscope is provided, comprising:
A valve seat comprising an opening, and
A valve member comprising a valve member body and a sealing ring on a first surface of the valve member body, wherein the valve member is movable between a first position where the sealing ring seals around the opening and a second position where the valve member is spaced apart from the opening, and a lubricant at least one point of sliding contact between the valve member and a further part of the valve.

According to further aspects, corresponding valve members are provided. According to a further aspect, a charged particle beam microscope comprising any of the valves discussed above is provided.

### BRIEF DESCRIPTION OF THE DRAWINGS

Various embodiments will be described with respect to the attached drawings, wherein:
Figures 1A-1F are various views of valves and valve members according to embodiments,
Figures 2A and 2B are side views of valves and valve members according to further embodiments,
Figures 3A and 3B are side views of valves and valve members according to further embodiments,
Figures 4A and 4B are views of valves illustrating the use of a lubricant according to some embodiments,
Figures 5A and 5B are views of valves according to a comparative example, and
Figure 6 is a schematic diagram of a charged particle beam microscope.

### DETAILED DESCRIPTION

In the following, various embodiments of valves and valve members for charged particle beam microscopes will be discussed. The valves and valve members discussed may in particular separate a first chamber where a charged particle beam like an electron beam is generated from a second chamber where the sample is provided, for example to preserve a vacuum. As an example, the valves discussed may be used as valve 65 in the charged particle beam microscope of Fig. 6 described above.

Features from different embodiments may be combined to form further embodiments. For example, different embodiments may include different modifications compared to the comparative example discussed in the introductory portion with respect to Figures 5A-5D, and these variations may be used independently or in various combinations with each other. On the other hand, in a single embodiment shown in the figures and described herein more than one such variation may be present, and also in this case the variations may be used independently from each other or in combination.

In the figures, like components are designated with the same reference numerals and will not be describe repeatedly.

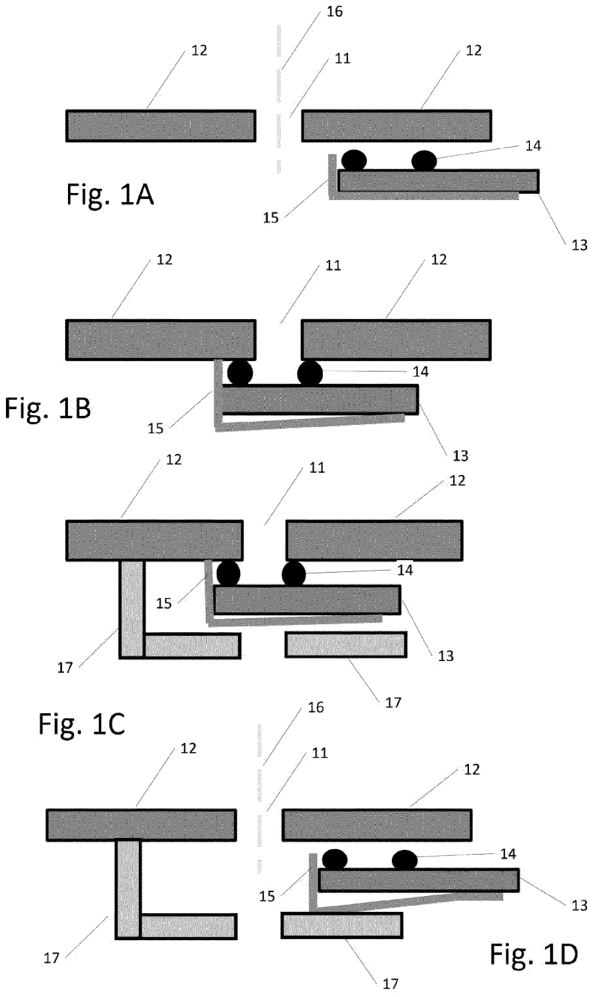

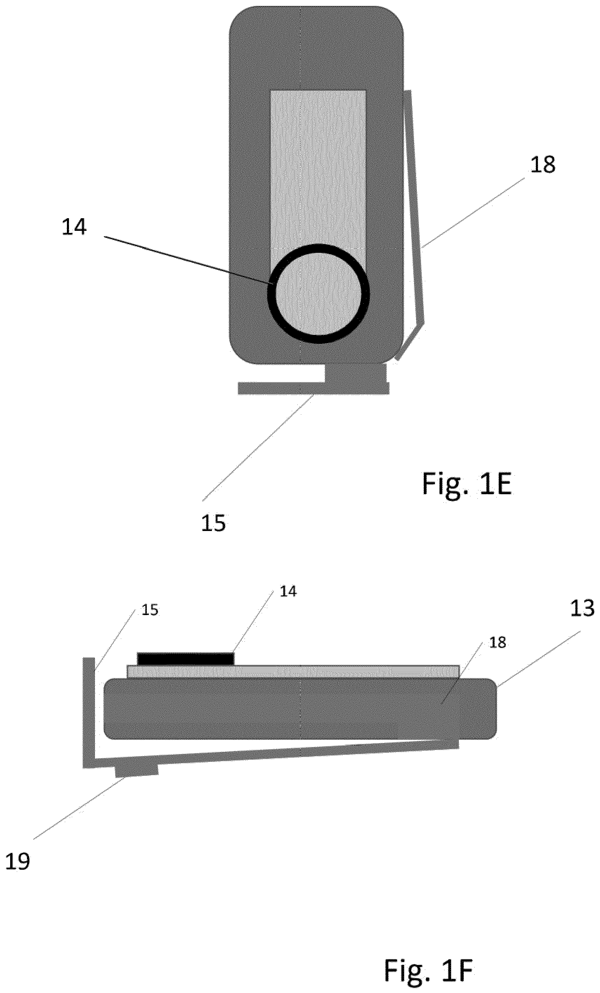

Fig. 1A is a side view of a valve according to an embodiment in an open position, and Fig. 1B is a side view of the valve of Fig. 1A in a closed position. Figures 1E and 1F show perspective views of example implementations of the valve of Figures 1A and 1B.

The valve of Figures 1A, 1B, include a valve seat 12 with an opening 11. In operation, a charged particle beam 16, for example an electron beam, passes through opening 11.

The valve further comprises a valve member including a valve member body 13, a sealing ring 14 disposed on a first side of the valve member body 13, and a shielding 15. As can be seen in Fig. 1B, in the closed position (also referred to as first position herein) sealing ring 14 seals around opening 11, for example to prevent a vacuum loss.

Shielding member 15 is made of an electrically conducting material, for example a metal or metal alloy, and extends on a side of valve member body 13 which faces opening 11 and charged particle beam 16 in the open position if the valve member (also referred to as second position herein) of Fig. 1A. Shielding 15 extends above the first surface, such that sealing ring 14 is shielded from the charged particle beam 16, which in some embodiments may prevent charging of sealing ring 14.

As can been in Fig. 1A and 1B, shielding 15 may be attached to second side of valve member body 13 opposite the first side (where sealing ring 14 is provided), such that shielding member 15 is fixed in a spring-like manner. In the closed position of Fig. 1B, as shown shielding member 15 then abuts against valve seat 12 and establishes an electrical contact to valve seat 12. Valve seat 12 in the closed position may for example be set to a ground potential, and this contact of shielding member 15 to valve seat 12 contributes to also setting the valve member to ground potential.

As in conventional systems, as shown in Figures 1C and 1D, the valve may also include a valve housing member 17 which extends, in the figure, below the valve member. As shown in Fig. 1C, also in this case in the closed position shielding member 15 abuts against valve seat 12.

Moreover, in some embodiments, as shown in Fig. 1D in the open position shielding member 15 may press against valve housing member 17, such that in the open position shielding member 15 may be biased via valve housing member 17, for example to a high voltage potential. In other embodiments, in the open position shielding member 15 is not in contact with valve housing member 17 in the open position.

Furthermore, the valve member of Fig. 1E and 1F has an electrical spring contact 18 at a side thereof, which in the embodiment of Figures 1E and 1F is formed with shielding member 15 in one piece. In other embodiments, an implementation using separate pieces or elements for shielding member 15 may be used. Electrical spring contact 18 serves to additionally provide the conventional contacting for biasing the valve member, as explained in the introductory portion with respect to Figures 5C and 5D, see electrical spring contact 18 thereof. In this case, the biasing via shielding member 15 as shown in Figures 1B, 1C for the contact to the valve seat and in Fig. 1D for the contact to valve housing member 17 provides an additional contact to the conventional contact via electrical spring contact 18.

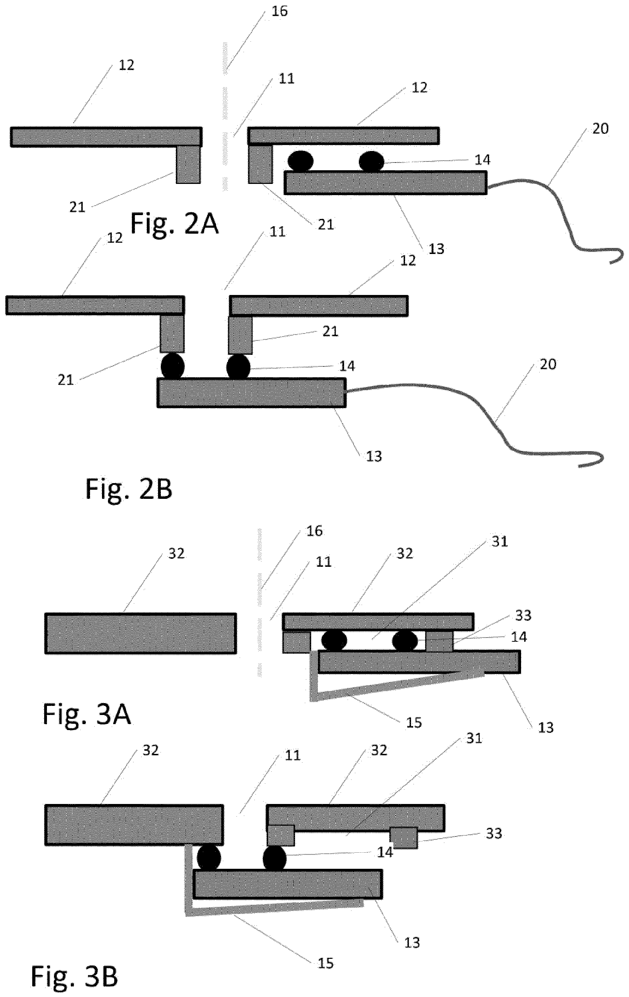

Figures 2A and 2B illustrate a valve according to a further embodiment, where Fig. 2A shows the open case where the valve member is in the second position, and Fig. 2B shows the closed case where opening 11 is sealed.

Instead of the shielding 15 provided in the embodiment of Fig. 1A-1K here a further shielding 21 is provided which extends from valve seat 12 and surrounds opening 11. In the position shown in Fig. 2A, further shielding 21 is interposed between the sealing ring 14 and the charged particle beam 16, such that a charging of sealing ring 14 is prevented or at least reduced. In the first state shown in Fig. 2B, sealing ring 14 abuts against further shielding 21, thus sealing opening 11.

In some embodiments, further shielding 21 may be combined with shielding 15 discussed previously.

Furthermore, in the embodiment of Figures 2A and 2B an electrically conducting member20 is attached to valve member body 13. Using electrically conducting member 20, the valve member may be securely biased to a high voltage or to ground in some embodiments. In some embodiments, electrically conducting member 20 may be a flexible member like a wire or a cable like a ribbon cable. In other embodiments, electrically conducting member 20 may be fully or partially rigid, for example with a flexible contact or rolling contact remote from the valve member.

Fig. 3A and 3B illustrate a valve according to a further embodiment. Fig. 3A shows the second position (open position), and Fig. 3B shows the first position (close position).

Here, a valve seat 32 is provided which has a recess 31, into which sealing ring 14 is positioned in the open case of Fig. 3A, such that sealing ring 14 is shielded from charged particle beam 16. Additionally, an electrically conducting element 33 is provided, against which valve member body 13 abuts in the second position, thus providing an electrical contact for biasing the valve member. Note that in the embodiment of Fig. 3A and 3B shielding member 15 is provided and has the function as explained with reference to Figures 1A-1K, in particular abuts against valve seat 32 in the first position of Fig. 3B where the sealing ring 14 is pressed against valve seat 32 to seal around opening 11. Nevertheless, the recess and the electrical contact element 33 of Figures 3A and 3B may be provided independently from shielding member 15.

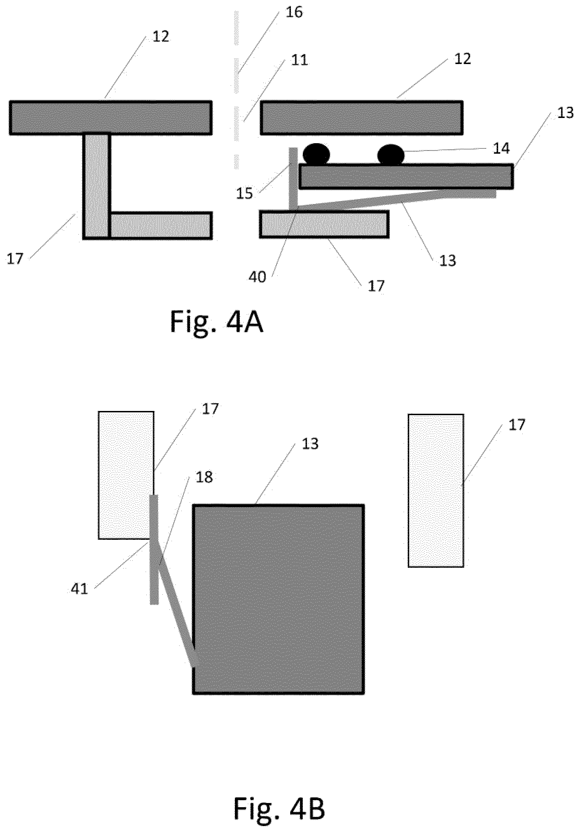

In further embodiments, together with the embodiments discussed above or independently thereon, a lubricant is used at points where a sliding electrical contact is established. This is illustrated in Figures 4A and 4B. Fig. 4A reproduces Fig. 1D. Reference numeral 40 indicates where shielding member 15 comes into sliding contact with valve housing member 17, which may correspond to the contact established by protrusion 19, as shown in Figures 1H and 1J. Fig. 4B shows a top view where electrical spring contact 18 comes into contact with valve housing member 17 or any other point, and as indicated by reference numeral 41 here also a lubricant may be used. The lubricant may protect from mechanical abrasion and generation of particles. Such an abrasion, besides problems which may generated by free particles in the charged particle beam microscope itself, may increase the surface of the corresponding contact elements like electrical spring contact 18 or shielding member 15, which in turn may increase an oxidation or other chemical reaction, which may reduce the quality of the electrical contact. For example, shielding 15 may be made of copper, bronze, or brass (like chromed brass), and in charged particle beam microscope NOCI gas may react with such metal to form copper chloride, which may provide an electrical isolation.Such NOCl gas is used as processing gas to locally etch structures in the samples by means of the electron beam, but may also inadvertedly react with other components in the device.

Suitable lubricants include fluoropolymers like so called TEM oil., or silicone grease based lubricants. [Examples include APIEZON ^{®} high vacuum grease or silicone high vacuum grease by Plano GmbH, or Lit-Oil 300 or 500 oils from the Zeiss Material catalog.

Therefore, various embodiments herein may increase the reliability of biasing of the valve member and/or may provide a shielding for a sealing ring, which may in some embodiments prevent or mitigate a deterioration of image quality or image position drift of the charged particle beam microscope.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A valve (65) for a charged particle beam microscope (60), comprising:
a valve seat (12; 32) comprising an opening (11), and
a valve member comprising a valve member body (13) and a sealing ring (14) on a first surface of the valve member body (13), wherein the valve member is movable between a first position where the sealing ring (14) seals around the opening (11) and a second position where the valve member is spaced apart from the opening (11),
wherein the valve member further comprises an electrically conducting shielding member (15) extending at least at a side surface of the valve member body (13) facing the opening (11) in the second position.

2. The valve (65) according to claim 1, wherein the shielding member (15) extends to a height at least corresponding to a height of the sealing ring (14) above the first surface of the valve member body (13) in the second position.

3. The valve (65) according to claim 1 or 2, wherein the shielding member (15) is attached to a second surface of the valve member body (13) opposite the first surface.

4. The valve (65) according to claim 3, further comprising a valve housing member (17) extending below the valve member, wherein the shielding member (15) is configured to electrically contact a conducting part of the valve housing member (17) in the second position.

5. The valve (65) according to claim 4, wherein the conducting part of the valve housing member (17) is configured to be set to a first voltage potential at least when the valve member is in the second position.

6. The valve (65) according to any one of claims 1 to 5, wherein the shielding member (15) is configured to electrically contact a conducting portion of the valve seat (12) when the valve member is in the first position.

7. The valve (65) according to claim 6, wherein the conducting part of the valve seat (12) is configured to be set to a second voltage potential at least when the valve member is in the first position.

8. The valve (65) according to any one of claims 1 to 7, wherein the valve member comprises an electrical contact spring (18) at a further side surface thereof, which is configured to receive a first voltage in the first position and a second voltage in the second position.

9. The valve (65) according to any one of the preceding claims, wherein the valve seat (12) comprises a further shielding member (21) around the opening, wherein the sealing ring (14) is configured to abut against the further shielding member (21) in the first position, and shielded by the further shielding member (21) in the second position.

10. The valve (65) according to any one of the preceding claims, wherein the valve member further comprises a flexible electrically conducting wire attached to the valve member body (13) and configured for biasing the valve member.

11. The valve (65) according to any one of the preceding claims wherein the valve comprises an electrical contact (33) configured to contact the valve member body (13) at the first surface for biasing in the second position.

12. The valve (65) according to any one of the preceding claims, wherein the valve seat (12, 32) comprises a recess (31) housing at least the sealing ring (14) in the second position.

13. The valve (65) according to any one of claims 1 to 12, further comprising a lubricant at at least one point (40, 41) of sliding contact between the valve member and a further part of the valve.

14. The valve (65) according to claim 13, wherein the lubricant comprises a fluoropolymer.

15. A valve (65) for a charged particle beam microscope, comprising:
a valve seat (12; 32) comprising an opening (11) and a shielding member (21) around the opening (11), and
a valve member comprising a valve member body (13) and a sealing ring (14) on a first surface of the valve member body (13), wherein the valve member is movable between a first position where the sealing ring (14) abuts against the shielding member (21) to seal the opening (11) and a second position where the valve member is spaced apart from the opening (11) and the sealing ring (14) is shielded by the shielding member (21).
wherein the valve member further comprises an electrically conducting shielding member (15) extending at least at a side surface of the valve member body (13) facing the opening (11) in the second position.

16. A valve (65) for a charged particle beam microscope, comprising:
a valve seat (12; 32) comprising an opening (11),
a valve member comprising a valve member body (13) and a sealing ring (14) on a first surface of the valve member body (13), wherein the valve member is movable between a first position where the sealing ring (14) seals around the opening (11) and a second position where the valve member is spaced apart from the opening (11), and
a lubricant at at least one point (40, 41) of sliding contact between the valve member and a further part of the valve.

17. A valve (65) for a charged particle beam microscope, comprising:
a valve seat (12; 32) comprising an opening (11), and
a valve member comprising a valve member body (13) and a sealing ring (14) on a first surface of the valve member body (13), wherein the valve member is movable between a first position where the sealing ring (14) seals around the opening (11) and a second position where the valve member is spaced apart from the opening (11),
wherein the valve seat (12, 32) comprises a recess (31) housing at least the sealing ring (14) in the second position.

18. A valve (65) for a charged particle beam microscope, comprising:
a valve seat (12; 32) comprising an opening (11),
a valve member comprising a valve member body (13) and a sealing ring (14) on a first surface of the valve member body (13), wherein the valve member is movable between a first position where the sealing ring (14) seals around the opening (11) and a second position where the valve member is spaced apart from the opening (11), and
an electrical contact (33) configured to contact the valve member body (13) at the first surface for biasing in the second position.

19. A valve member for a valve of a charged particle beam microscope (60) comprising:
a valve member body (13),
a sealing ring (14) on a first surface of the valve member body (13), and
an electrically conducting shielding member (15) extending at least at a side surface of the valve member body (13) and extending to a greater height above the first surface than the sealing ring (14).

20. A valve member for a valve (65) of a charged particle beam microscope comprising:
a valve member body (13),
a sealing ring (14) on a first surface of the valve member body (13), and
a electrically conducting member attached to the valve member body (13) and configured for biasing the valve member.

21. A charged particle beam microscope, comprising the valve (65) according to any one of claims 1 to 18 or a valve (65) comprising the valve member of claim 19 or 20.
